# EUROPEAN PATENT SPECIFICATION

(11) **EP 3 142 252 B1**
(45) Date of publication and mention of the grant of the patent: **14.11.2018**
(21) Application number: 15290228.4
(22) Date of filing: 10.09.2015
(51) Int. Cl.: H05K 1/02, H05K 1/18, H03F 1/56, H03F 3/189, H01L 23/64, H01L 23/66

(54) **VIDEO BANDWIDTH IN RF AMPLIFIERS**
VIDEOBANDBREITE IN HF-VERSTÄRKERN
LARGEUR DE BANDE VIDÉO DANS DES AMPLIFICATEURS RF

(43) Date of publication of application: 15.03.2017
(73) Proprietor: Ampleon Netherlands B.V., 6534 AV Nijmegen (NL)
(72) Inventor: Bouisse, Gerard Jean-Louis, 31770 Colomiers (FR)
(74) Representative: Jacobs, Bart

(56) References cited:
- EP-A1- 2 879 174
- EP-A2- 1 748 487
- WO-A2-03/063246
- , 24 July 2013 (2013-07-24), XP055257255, Retrieved from the Internet: URL:http://www.st.com/web/en/resource/tech nical/document/datasheet/CD00002116.pdf [retrieved on 2016-03-10]

## Description

### Field

This invention relates to a package lead for a package and in particular, but not exclusively, to an output package lead for radio-frequency (RF) amplifier package.

### Background

Power amplifier circuits are widely used in Radio Frequency (RF) applications.

Power amplifiers may be implemented with a form of impedance matching. Impedance matching may adjust an input and/or output impedance of the power amplifier in order to adjust characteristics of the circuit, for example power transfer or signal reflection. For example, in RF systems, matching the input impedance of the input of the integrated circuit die with the source impedance reduces the signal reflection.

The impedance matching may affect the video bandwidth of the amplifier. The video bandwidth (VBW), or instantaneous bandwidth, of an RF power amplifier represents the ability of the RF power amplifier to instantaneously amplify a linear signal (i.e. a signal with a variable envelope) without asymmetrical distortion.

The instantaneous bandwidth represents the broadest modulating signal that can be handled instantaneously by a RF power amplifier without asymmetrical distortion. Asymmetry in signal distortion is generally unacceptable because it is difficult to correct.

For mobile communication applications, signal modulations have become increasingly wideband over the past years (from 200kHz to 75MHz today and >100MHz in the future) so as to achieve higher data rates. Video bandwidth is therefore of growing importance and typically a discriminating factor in the field of amplification for mobile communication applications.

Thus the video bandwidth provided by a power amplifier with impedance matching is of interest. An example for an RF amplifier comprising a packaged power transistor device is given in EP2879174.

### Summary

According to a first aspect, there is provided a printed circuit board comprising an integrated circuit package according to claim 1.

### Figures

Embodiments will be described, by way of example only, with reference to the drawings, in which:
Figure 1 is an example schematic of impedance matching circuitry;
Figure 2 shows an example of a package and lead;
Figure 3 shows an example of a package on a printed circuit board; and
Figure 4 is a schematic of impedance matching circuitry in accordance with an example.

It will be appreciated that for features that span more than one drawing like reference numerals indicate the like feature.

### Detailed Description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the invention is, therefore, indicated by the appended claims rather than by this detailed description. All changes that come within the meaning and range of equivalency of the claims are to be embraced within their scope.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

RF amplifiers may be generally implemented with integrated circuit die (chips) provided in a package. The integrated circuit die may comprise on-chip circuitry providing the RF amplifier as well as input and output terminals. In some examples, these input and output terminals may be gate and drain connections respectively for on-chip transistors providing the power amplifier. The package may comprise input and output leads provided to couple the package further, for example to other components on a printed circuit board (PCB). The input and output terminals of the integrated circuit die may be coupled to the input and output package leads via bond wires and/or other in-package circuitry.

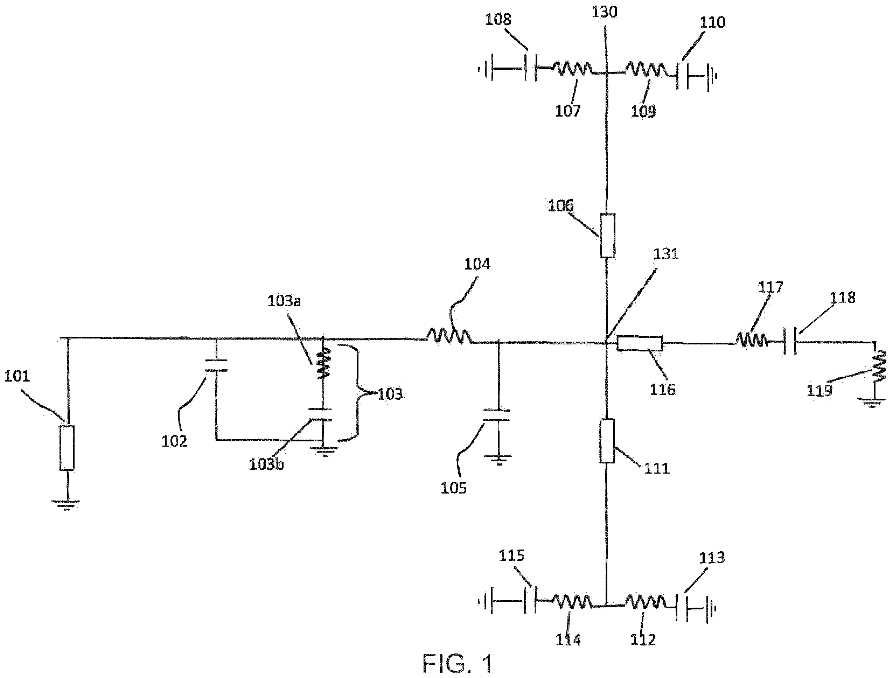

RF amplifiers may be provided with an impedance matching network for performing impedance matching. Figure 1 is an electrical representation of a possible impedance matching structure 100 as it is used in an RF simulator. The matching structure depicted in figure 1 is an output impedance matching structure. The possible impedance matching structure 100 of figure is the representation of an electrical circuit describing typical passive elements from a current source 101 of an active device through internal and external (to the package) matching elements, as well as connection 130 to the DC power supply and terminating in a 50 ohm load 119. In specific examples, the active device may be a transistor providing the amplification of an RF signal.

Element 101 represents the current source of the transistor. A shunt capacitance 102 is provided representing a shunt capacitance between the drain and source of the transistor. The element 101 and shunt capacitor 102 may correspond to the impedance provided by the transistor implemented on an integrated circuit die. The shunt capacitor 102 may represent the output capacitance of the transistor. The transistor may be provided on an integrated circuit within a package. In-package matching elements 103a and 103b may be provided between an output terminal 120 of the integrated circuit die and an output lead of the package.

The in-package matching elements are represented by a series inductor capacitor network 103 coupled between the output terminal 120 of the integrated circuit die and ground and an inductor 104 coupled between the output terminal of the integrated circuit die 120 and the output package lead. The inductor capacitor network 103 comprises an inductor 103a and capacitor 103b and may form a shunt inductor 103 for impedance matching. In some implementations in practice, the inductor 103a may be provided by bond wires forming a connection between the output terminal 120 of the integrated circuit die and the dc-blocking capacitor 103b. The inductor 04 may be provided by the inductance of bond wire connections between the output terminal 120 of the integrated circuit die and the output lead of the package.

A shunt capacitor 105 is provided coupled between the inductor 104 and ground. This capacitor 105 may represent the impedance provided by the output package lead. The lead 105 is further coupled to a first network 106 to 110, a second network 111 to 115 and a third network 116 to 118. The first 106 to 110, second 111 to 115 and third 116 to 118 networks in this example may comprise components mounted on a PCB and coupled to the output lead at node 131.

The first 106 to 110 and second networks are provided to couple a dc supply to the node 131 and shunt any unwanted RF and baseband signals in these networks to ground. Thus the first and second networks may provide a dc feeding network. The first network comprises a first transmission line 106 coupled between the node 131 and inductors 107 and 109. The inductor 107 is coupled to ground via an RF decoupling capacitor 108. The inductor 109 is coupled to ground via a baseband decoupling capacitor 110. A node 130 between the inductors 107 and 109 and transmission line 106 is coupled to a dc power supply. The second network comprises a second transmission line 111 coupled to inductors 112 and 114. The inductor 112 is coupled to ground via a baseband decoupling capacitor 113 and the inductor 114 is coupled to ground via a RF decoupling capacitor 115. The first and second networks are therefore symmetrical except for the dc supply coupled to the node 130 of the first network.

In operation, RF signals may be output on the package lead at node 131. The first and second transmission lines 106 and 111 may be high impedance lines and may provide the DC supply to the node 131 while blocking the RF signals from traversing the transmission lines 106, 111. Some RF signals may however be present on the lines 106 and 111. The RF decoupling capacitors 108 and 115 may act as shorts at RF frequencies and thus shunt any RF signals to ground. Baseband components may also be present at node 131, for example due to distortion, and the baseband decoupling capacitors 110 and 113 may shunt these to ground in the first and second networks.

The third network may provide an output path for the RF signals present at the node 131 to a load 119 and may comprise a third low impedance transmission line 116. The third transmission line 116 may be coupled to a dc-blocking inductor 117 and capacitor 118 which block the dc signals present at node 131 from being passed to the load 119. In operation, RF signals at the node 131 may traverse the low impedance transmission line 116 and be provided to further circuitry represented by load 119. In some examples, the terminating load can be considered to be 50 ohms.

The instantaneous bandwidth performance of an impedance matched active device, such as that represented by the circuitry of figure 1, may be directly linked to the electrical distance between a current source 101 of the active device 101 and the envelope or baseband decoupling capacitor 113, 110. It will be appreciated that the electrical distance of the baseband decoupling capacitor 113, 110 from the current source may be dependent on the position of the RF decoupling capacitors 108, 115 due to a layout of the circuitry.

In the example of figure 1, the electrical distance between the current source 101 and the baseband decoupling capacitor 113, 110 includes the inductances 104 and 112, 109 as well as the transmission lines 106, 111. The magnitude of the connecting inductance between the RF and baseband decoupling capacitances 113 and 115 may affect the instantaneous bandwidth of the active device. The shunt inductor network 103 provided between the integrated circuit die and the package lead may increase the inductance 104 as the length of the bond wires forming the inductance 104 need to be long enough to span the network 103 to reach the output package leads. This may further increase the electrical distance.

Ideally, this electrical distance can be shortened by implementing the RF and baseband decoupling as part of the in-package shunt inductor network 103. This would require that the decoupling capacitor 103b of the in-package shunt inductor network 103 represent a short at both RF and baseband frequencies, however it will be appreciated that such a capacitor is not possible.

Embodiments of the present disclosure introduce a structure for the package lead of a package. The package lead structure may incorporate a shunt inductor. The shunt inductor provided by the package lead may replace the in-package impedance matching shunt inductor network 103 of figure 1. The package lead may allow RF and baseband decoupling capacitors to decouple at a same node and aim to reduce the connecting inductance between the RF and baseband decoupling capacitors and an active device.

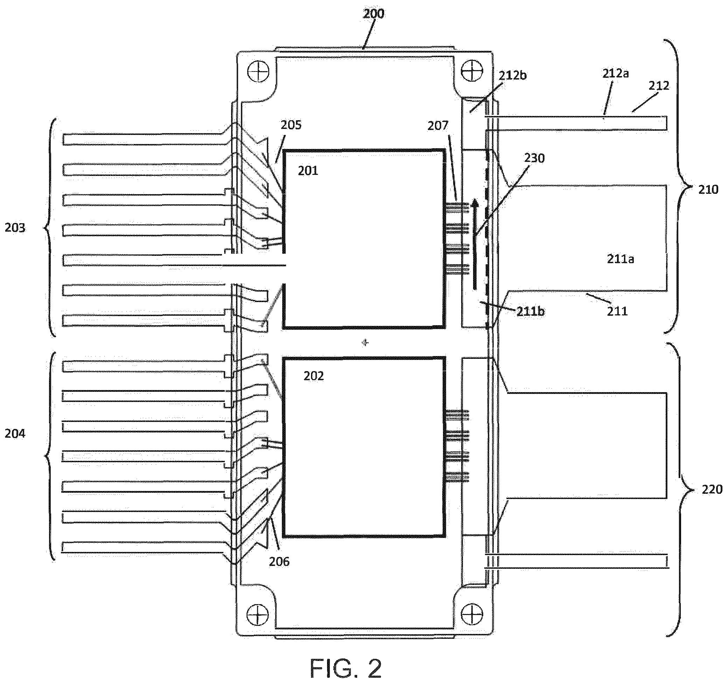

Figure 2 shows an example of a package having output package leads in accordance with an example.

The package 200 comprising a first integrated circuit die 201 and a second integrated circuit die 202. First and second input package leads 203 and 204 are provided to couple the package 200 to components on a printed circuit board (PCB). First input connections 205 are provided in the package 200 to couple the first input package leads 203 to one or more input terminals of the first integrated circuit die 201. Second input connections 206 are provided in the package 200 to couple the second input package leads 204 to one or more input terminals of the second integrated circuit die 202. In some examples the connections 205 and 206 may comprise bond wire connections. In some examples in-package impedance matching circuitry may be provided between the input package leads 203, 204 and the one or more input terminals of the first and second integrated circuit dies 201 and 202.

The package 200 may comprise first output connections 207 configured to couple one or more output terminals of the first integrated circuit die 201 to a first output package lead 210. The package may comprise second output connections 208 configured to couple one or more output terminals of the second integrated circuit die 202 to a second output package lead 220. The first and second output connections 207 and 208 may, in some examples, comprise one or more bond wires between the integrated circuit die output terminals and the output package leads.

In this example, the functionality of the in-package shunt inductor network 103 of figure 1 is implemented using the output package lead 210, 220. Because the in-package matching circuitry 103 is removed, the integrated circuit die 201, 202 may be mounted closer to the side of the package 200 and thus the bond wires 207, 208 may be shorter than their counterparts depicted by 104 in figure 1. This may reduce the contribution to the electrical distance made by coupling the integrated circuit to the output leads.

While the package 200 has been depicted as comprising two integrated circuit die 201 and 202, it will be appreciated that this is by way of example only and the package may comprise one or more circuit die. The package 200 may be mounted on a PCB and in the input and output package leads 203, 204, 210 and 220 may be configured to couple the package to the PCB and/or to further components on the PCB.

The first and/or second integrated circuit die 201, 202 comprise one or more active devices. For example, the integrated circuit die comprises one or more transistors forming an amplifier.

In accordance with examples of the present disclosure, the output package lead (for example package lead 210 or 220) is implemented to provide an output impedance matching shunt inductor and connection to components on the PCB. By incorporating an impedance matching shunt inductor for the active device on the integrated circuit die into the output package lead, an electrical distance from the active die to RF and baseband decoupling capacitors may be shortened in some examples.

The first output package lead 210 couples the package 200 to further components on a PCB. In particular, the output package lead 210 may be coupled to output terminals of an integrated circuit die within the package via output connections 207 of the integrated circuit die.

The first output package lead 210 comprises a first portion 211 and a second portion 212. The first portion 211 has a relatively low impedance with respect to the second portion 212 and the second portion 212 has a relatively high impedance with respect to the first portion 211. The first portion may be considered to be suitable as an RF lead and the second portion may be suitable as a direct current (DC) lead.

The first portion 211 comprises a first coupling portion 211b and a first extending portion 211a. The first coupling portion 211b is configured to provide a coupling point for connections to the integrated circuit die. The first extending portion 211a may provide a coupling point to one or more components on the PCB. The first extending potion 211a and the coupling portion 211b may be integral.

The second portion 212 comprises a second coupling portion 212b and a second extending portion 212a. The second coupling portion 212b is configured to be coupled to the first coupling portion 211b. The second extending portion 212b is configured to provide a coupling point to one or more components on the PCB. In particular, the second extending portion 212b Provides a coupling to an RF decoupling capacitor and a baseband decoupling capacitor provided on the PCB. In some examples, the second extending portion 212b may further be coupled to a DC source. The second extending potion 212a and the second coupling portion 212b may be integral.

The first coupling portion 211b and the second coupling portion 212b are directly coupled to each other. In some examples, the first and second coupling portions may be integral. The first and second extending portions 211a and 212b are not coupled to each other. The area of the first portion 211 that is coupled to the second portion 212 may be considered to be the first coupling portion 211a and the area of the first portion that is not coupled to the second portion 212 may be considered to be the first extending portion 211b. Similarly, the area of the second portion 212 that is coupled to the first portion 211 may be considered to be the second coupling portion 212a and the area of the second portion 212 that is not coupled to the first portion 211 may be considered to be the second extending portion 212b.

The second output lead 220 of figure 2 may have a structure in line with that of the first output lead 210. While figure 2 depicts two output package leads 210 and 220, examples of the present disclosure may be directed to one or more output package leads.

The first coupling portion 211b may be provided to couple the output package lead to the active device. The first coupling portion 211b may be coupled to the active device by output connections 207. In an example these output connections may comprise a plurality of bond wire connections between one or more output terminals of the active device and the first coupling portion 211b. In one example, the connections 207 directly couple the output terminals of the active device to the first coupling portion 211b. In some examples, the connections 207 are kept as short as possible by arranging the output terminals of the active device to be as close as possible to the first coupling portion 211b. In some examples, the output connection 207 are provided as a plurality of short bond wire connections to attempt to minimise a series inductance cause by the output connections 207.

In operation, signals output from the active devices on the integrated circuit die 201 are output via the output connections 207 to the output lead 210. The output lead may realise an impedance matching shunt inductor by causing the propagation of signals from the first coupling portion 211a to the second coupling portion 212b. It will be appreciated that due to the relative high impedance of the first coupling portion 211b with respect to the second coupling portion, the majority of the RF signals will propagate down the first extending portion 211a, however some signals will propagate across the first coupling portion 211b to the second coupling portion 212b and to the second extending portion 212a. This may provide an inductance. The signals that have orthogonally propagated may be terminated in baseband and RF decoupling capacitors coupled to the second extending portion 212a. The propagation is orthogonal to the direction of extension of the first and second extending portions 211a and 212a. The propagation of the signals is shown by arrow 230.

RF and baseband decoupling capacitors are implemented on the PCB. The RF decoupling capacitor acts as an electrical short for RF frequencies and shunt these frequencies to ground. The baseband capacitor acts as an electrical short at baseband frequencies and shunt these frequencies to ground. In this manner, the in-package matching network 103 of figure 1 may be provided by the output lead 210, 220 and the RF and baseband decoupling capacitors.

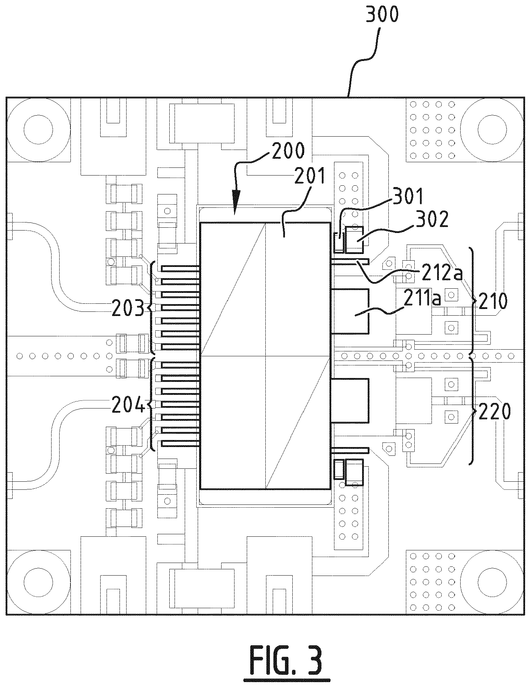

Figure 3 shows a schematic of a portion of a PCB comprising an output package lead according to examples and RF and baseband decoupling capacitors. It will be appreciated that the package 200 may be similar to that depicted in figure 2 and like reference numerals may depict like features.

Figure 3 shows a package 200 comprising first and second integrated circuit die 201, 202, input package leads 203 and 204 and output package leads 210 and 220. First and second extending portions 211a and 212a of the first package lead 210 is shown. It will be appreciated that the first and second coupling portions 211b and 212b may be obscured by a lid of the package 200. The package 200 is provided on a printed circuit board (PCB) 300.

Figure 3 further shows a first capacitor 301 and a second capacitor 302. The first capacitor may be an RF decoupling capacitor and the second capacitor may be a baseband decoupling capacitor. The second or RF decoupling capacitor 301 may be smaller than the second or baseband decoupling capacitor 302. In one example the RF decoupling capacitor 301 may have a value of 2.7pF and the baseband decoupling capacitor may have a value of 10µF however it will be appreciated that the values will be dependent on the application of the package 300.

The first and second capacitors 301 and 302 may be coupled at a same node. The first and second capacitors may further be coupled to the second extending portions 212a and the shunt inductance provided by the first and second coupling portions 211a and 212b provided by the output lead 210. The electrical distance between the RF and baseband decoupling capacitors 301 and 302 may thus be shortened with respect to figure 1.

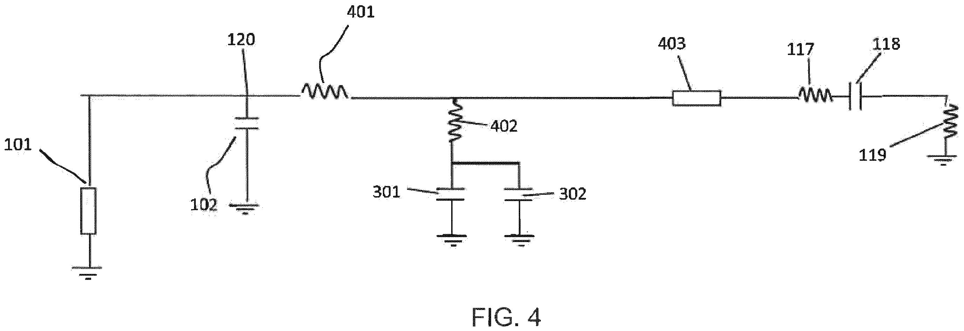

Figure 4 is an electrical representation of the impedance matching structure in accordance with the example of figure 3. Figure 4 is a representation of an electrical circuit describing an example of the passive elements from a current source 101 of an active device on an integrated circuit die 201 through internal and external (to the package) matching elements and output lead, as well as connection to the DC power supply and terminating in a 50 ohm load 119. In some examples, the active device is a transistor providing an RF amplifier.

Element 101 represents the current source of the transistor on the integrated circuit die. The shunt capacitance 102 represents the shunt capacitance between the drain and source of the transistor. In this example, the integrated circuit die does not comprise an in-package matching shunt inductor network, but this is provided rather by the output lead 210.

The output terminal 120 of the integrated circuit die 201 is coupled to the output lead 210 of the package 200 via bond wire connections 207 represented by the inductor 401. Because the package 200 does not comprise in-package matching circuitry 103, the bond wires coupling the output of the integrated circuit die to the output lead may be shorter than those described in relation to figure 1. Thus the inductor 401 representing those bond wires may have a smaller value than the inductance 104 in figure 1.

In this example, the output lead 210 is represented by the inductance 402. This may be the shunt inductance realised by the output lead 210 by the orthogonal signals along the first and second coupling portion 211b and 212b and indicated by the arrow 230 in figure 2. The inductance 402 may represent the orthogonal path 230 from the high impedance portion 211 to the low impedance portion 212 of the output lead 210. The output lead 210 may be directly coupled to an RF decoupling capacitor 301 and a baseband decoupling capacitor 302. The capacitors 301 and 302 may be coupled in parallel at a same node. Because the coupling is at the same node, the inductance of the coupling may be less than if they were coupled at separate node and in some examples can be omitted as negligible. The output lead 210 may further be coupled to low impedance transmission line 403 and dc-blocking circuitry 117, 118 which is further coupled to the load 119.

It can be seem from the figures that the electrical distance from the current source 101 to the baseband decoupling capacitors 110 and 113, in figure 1 is larger than the electrical distance from the current source 101 to the baseband decoupling capacitor 302 in figure 4.

The described embodiments are to be considered in all respects only as illustrative and not restrictive. The scope of the invention is, therefore, indicated by the appended claims rather than by this detailed description. All changes that come within the meaning and range of equivalency of the claims are to be embraced within their scope.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to an example or embodiment, or similar language means that a particular feature, structure, or characteristic described in connection with the indicated embodiment is included in at least one embodiment. Thus, the phrases "in one example" "in an example" and similar language throughout this specification may, but do not necessarily, all refer to the same embodiment.

## Claims

1. A printed circuit board comprising:
an integrated circuit package (200) comprising:
a first integrated circuit die (201) having one or more output terminals, wherein the first integrated circuit die comprises one or more transistors;
a first output package lead (210);
a first output connection (207) comprising one or more bond wires between the one or more output terminals and the first output package lead, the first output package lead comprising a first portion (211) having a low impedance, and a second portion (212) having a high impedance,
wherein the first and second portions are coupled together and the first portion is further coupled to the one or more output terminals, the first portion comprising a first coupling portion (211b) and a first extending portion (211a), the second portion comprising a second coupling portion (212b) and a second extending portion (212a), and the first and second coupling portions being directly coupled together;
the printed circuit board further comprising:
a RF decoupling capacitor (301) coupled in between the second extending portion and ground, and a baseband decoupling capacitor (302) coupled in between the second extending portion and ground, wherein the RF decoupling capacitor acts as an electrical short for RF frequencies and wherein the baseband decoupling capacitor acts as an electrical short at baseband frequencies.

2. The printed circuit board of claim 1, wherein the second extending portion and first extending portion are arranged spaced apart and extend parallel to each other.

3. The printed circuit board of claim 1 or 2, wherein the first and second coupling portions are coupled in an integral manner.

## Patentansprüche

1. Leiterplatte, die aufweist:
ein integriertes Schaltungsgehäuse (200), das aufweist:
einen ersten integrierten Schaltungschip (201) mit einem oder mehreren Ausgangsanschlüssen, wobei der erste integrierte Schaltungschip einen oder mehrere Transistoren aufweist;
einen ersten Gehäuseausgangsdraht (210);
eine erste Ausgangsverbindung (207), die einen oder mehrere Bonddrähte zwischen dem einen oder den mehreren Ausgangsanschlüssen und dem ersten Gehäuseausgangsdraht aufweist, wobei der erste Gehäuseausgangsdraht einen ersten Abschnitt (211) mit geringer Impedanz und einen zweiten Abschnitt (212) mit hoher Impedanz hat,
wobei die ersten und zweiten Abschnitte miteinander gekoppelt sind und der erste Abschnitt ferner mit dem einen oder den mehreren Ausgangsanschlüssen gekoppelt ist, wobei der erste Abschnitt einen ersten Kopplungsabschnitt (211b) und einen ersten Erstreckungsabschnitt (211a) aufweist, wobei der zweite Abschnitt einen zweiten Kopplungsabschnitt (212b) und einen zweiten Erstreckungsabschnitt (212a) aufweist, und wobei die ersten und zweiten Kopplungsabschnitte direkt miteinander gekoppelt sind;
wobei die Leiterplatte ferner aufweist:
einen RF-Entkopplungskondensator (301), der zwischen den zweiten Erstreckungsabschnitt und Erde gekoppelt ist, und einen Basisbandentkopplungskondensator (302), der zwischen den zweiten Erstreckungsabschnitt und Erde gekoppelt ist, wobei der RF-Entkopplungskondensator als ein Kurzschluss für RF-Frequenzen wirkt, und wobei der Basisbandentkopplungskondensator als ein Kurzschluss bei Basisbandfrequenzen wirkt.

2. Leiterplatte nach Anspruch 1, wobei der zweite Erstreckungsabschnitt und der erste Erstreckungsabschnitt voneinander beabstandet sind und sich parallel zueinander erstrecken.

3. Leiterplatte nach Anspruch 1 oder 2, wobei die ersten und zweiten Kopplungsabschnitte in einer integralen Weise gekoppelt sind.

## Revendications

1. Carte de circuit imprimé comprenant :
un boîtier de circuit intégré (200) comprenant :
une première puce de circuit intégré (201) ayant une ou plusieurs bornes de sortie, dans laquelle la première puce de circuit intégré comprend un ou plusieurs transistors ;
un premier fil de sortie de boîtier (210) ;
une première connexion de sortie (207) comprenant un ou plusieurs câbles de raccordement entre les une ou plusieurs bornes de sortie et le premier fil de sortie de boîtier, le premier fil de sortie de boîtier comprenant une première partie (211) ayant une faible impédance, et une seconde partie (212) ayant une impédance élevée,
dans laquelle les première et seconde parties sont couplées ensemble et la première partie est en outre couplée aux une ou plusieurs bornes de sortie, la première partie comprenant une première partie de couplage (211b) et une première partie d'extension (211a), la seconde partie comprenant une seconde partie de couplage (212b) et une seconde partie d'extension (212a), et les première et seconde parties de couplage étant directement couplées ensemble ;
la carte de circuit imprimé comprenant en outre :
un condensateur de découplage RF (301) couplé entre la seconde partie d'extension et la terre, et un condensateur de découplage en bande de base (302) couplé entre la seconde partie d'extension et la terre, dans laquelle le condensateur de découplage RF agit comme un court-circuit électrique pour les fréquences RF et dans laquelle le condensateur de découplage en bande de base agit comme un court-circuit électrique aux fréquences en bande de base.

2. Carte de circuit imprimé selon la revendication 1, dans laquelle la seconde partie d'extension et la première partie d'extension sont agencées espacées l'une de l'autre et s'étendent parallèlement l'une à l'autre.

3. Carte de circuit imprimé selon la revendication 1 ou 2, dans laquelle les première et seconde parties de couplage sont couplées d'une manière intégrale.
